# EUROPÄISCHE PATENTANMELDUNG

(11) **EP 0 723 159 A1**
(43) Veröffentlichungstag der Anmeldung: **24.07.1996**
(21) Anmeldenummer: 95100459.7
(22) Anmeldetag: 14.01.1995
(51) Int. Cl.: G01R 15/18, H01F 38/28

(54) **Strommessvorrichtung mit Messwandler**

(71) Anmelder: Kommanditgesellschaft Ritz Messwandler GmbH & Co., D-20251 Hamburg (DE)
(72) Erfinder: Däumling, Holger, Dr.-Ing., 22885 Barsbüttel (DE)
(74) Vertreter: Vonnemann, Gerhard, Dr.-Ing.

(57) **Zusammenfassung**

Die Erfindung betrifft eine Strommeßvorrichtung für Nieder-, Mittel-und Hochspannungsanlagen bestehend aus einem Meßwandler und einem Außenabschlußwiderstand (3) zur Signalverarbeitung, wobei als Meßwandler ein induktiver Wandler mit einem Innenwiderstand vorgesehen ist, der größer als der Außenabschlußwiderstand ist.

## Beschreibung

Die Erfindung betrifft eine Strommeßvorrichtung für Nieder-, Mittel- und Hochspannungsanlagen bestehend aus einem Meßwandler und einem Außenabschlußwiderstand zur Signalverarbeitung.

Klassische Stromwandler werden beispielsweise in Schaltanlagen zur Überwachung, zum Schutz und für Steuerzwecke eingesetzt.

Sie stellen ein Stromsignal zur Verfügung, das proportional zum primärseitigen Strom ist, und sind gleichzeitig in der Lage, Leistungen bis einige Hundert VA abzugeben.

In der VDE 0414 Teil 1 ist ein Stromwandler definiert als ein Meßwandler, bei dem unter üblichen Betriebsbedingungen die Sekundärstromstärke der Primärstromstärke praktisch proportional ist und ihr gegenüber um einen Winkel abweicht, der bei vorgegebenem Anschluß annähernd null ist. Stromwandler bestehen im wesentlichen aus einer Primärwicklung, durch die der zu messende Strom fließt und eine Sekundärwicklung, an der die Meßgeräte, Elektrizitätszähler, Schutzrelais oder ähnliche Einrichtungen angeschlossen werden. Als Bürde wird dabei die Impedanz des Sekundärkreises bezeichnet, die in Ohm mit Angabe des Leistungsfaktors ausgedrückt wird.

Der Nachteil dieser klassischen bekannten induktiven Wandler ist, daß sie relativ großvolumig bauen und ihr Übertragungsbereich, in dem sie mit den bekannten Fehlertoleranzen genutzt werden können, aufgrund der abzugebenden Leistung eingeschränkt ist. Überschreitet nämlich der zu messende Strom einen bestimmten Wert, so geht das Eisen des Meßwandlerkerns in Sättigung. Teilweise kann dem dadurch entgegengewirkt werden, daß der Kern aufgeteilt wird in einen "kleinen" Meßkern, der relativ früh sättigt, und einen "großen" Schutzkern, der einen Überstrom noch messen kann, der um eine Zehnerpotenz höher als der Nennstrom ist. Derartige Maßnahmen erfordern jedoch den Einbau von großen Kernen mit relativ großen Massen an Eisen, die eine entsprechend großvolumige Bauweise bedingen. Wegen der großen Eisenmassen und der dafür erforderlichen großen Drahtlängen der Sekundär-Wicklungen weisen solche Wandler auch relativ hohe Eigenverluste auf.

Bei Nennstromstärken von kleiner 400 A müssen derartige Wandler oft als Wickelwandler ausgeführt werden, was Wicklungsaufwand und Verluste zusätzlich erhöht.

Der Stand der Sekundärtechnik hat sich so entwickelt, daß sich die EVU's heute zur Überwachung der Versorgungsnetze auch Überströme sehr genau zu messen wünschen.

Es ist Stand der Technik, für diese Zwecke vereinzelt eisenlose, sogenannte Rogowski-Wandler, einzusetzen, die ein den Stromänderungen proportionales Spannungssignal liefern.

Nachteil dieser Geräte ist, daß sie einen aufwendigen Trägerkörper, eine sehr homogene Sekundärwicklung sowie einen nachgeschalteten Integrator benötigen, der den Übertragungsbereich wieder einschränkt. Außerdem ist es nur mit nachträglichen Korrekturen für Formtoleranz, Wicklungszahl und thermischer Ausdehnung in einem Elektronikteil möglich, Genauigkeiten besser als Klasse 0,5 im Nennbereich zu erreichen.Zusätzlich zu diesen Nachteilen kann der Rogowski-Wandler, analog zu anderen Sensortechniken, keine Leistung aus dem Primärkreis herausnehmen und ist für die Elektronik auf Hilfsenergie angewiesen.

Aufgabe der Erfindung ist es, einen nach dem induktiven Prinzip arbeitenden kompakten Wandler anzugeben, der in der Lage ist, auch große Überströme sättigungsfrei und mit hoher Genauigkeit zu übertragen.

Diese Aufgabe wird bei einer Strommeßeinrichtung für Nieder-, Mittel- und Hochspannungsanlagen, bestehend aus einem Meßwandler und einem Außenabschluß, durch die kennzeichnenden Merkmale des Patentanspruchs 1 gelöst.

Weitere vorteilhafte Ausgestaltungen sind in den Ansprüchen 2 bis 10 beschrieben.

Als Meßwandler wird also ein induktiver Wandler, bestehend aus Primärwicklung, kleinem Kern und Sekundärwicklung mit verstärktem Querschnitt und ein Außenabschlußwiderstand so kombiniert, daß der Innenwiderstand des Wandlers um vorzugsweise eine Zehnerpotenz über dem Abschlußwiderstand liegt.

Aufgrund der geringen Eisenmassen und der kleinen Außen- und Innenbürden kann der erfindungsgemäße Wandler als leistungsloser induktiver Wandler bzw. als induktiver Sensor bezeichnet werden.

Besonders vorteilhaft ist, daß bei minimaler Leistungsentnahme das Gerät bis hin zu sehr kleinen Stromstärken als Einleiterwandler ausgeführt ist. Die Leistungsabgabe ist beispielsweise << 1 VA.

Dadurch, daß der Wandler einen Spannungsausgang aufweist, wobei vorzugsweise am Außenabschlußwiderstand eine Spannung abfällt, kann der Wandler quasi wie ein Wandler mit Rogowski-Kern verwendet werden. Er liefert somit ein dem Primärstrom proportionales Spannungssignal.

Beim klassischen Wandler ist es üblich, die Übersetzung des Wandlers auf den Nennstrom der Anlage zu beziehen. Ein Grund dafür liegt sicher darin, daß Ströme, die sehr viel größer als der Nennstrom sind, gar nicht übertragen werden können.

Beim erfindungsgemäßen Wandler, der auch sehr große Ströme sättigungsfrei überträgt, ist es sinnvoll, die Übersetzung auf den maximal zu erwartenden Strom und die maximal zulässige Eingangsspannung der Steuerelektronik auszurichten. So ist typischerweise ein thermischer Kurzschlußstrom von 25 kA_{eff} über denen Abschlußwiderstand von 1 Ω an eine Ausgangsspannung von 10 V ₚₑₐₖ gekoppelt.

Da das Gerät so ausgelegt ist, daß auch größere Ströme z.B. 63 kA sättigungsfrei übertragen werden können, kann durch Tausch des Abschlußwiderstands die Schnittstelle auch an einen höheren Jₜₕₑᵣₘ angepaßt werden (z.B. 0,625 Ω für 40 kA).

Andererseits kann das erfindungsgemäße Gerät Ströme bis hinunter zu 5 A mit Genauigkeiten von 0,2% messen, so daß hier für den technisch hauptsächlich verwendeten Nennstrombereich von 25 A bis 2500 A ein Einheitswandler vorliegt, der für Schaltanlagenhersteller und EVU's bedeutende logistische Vorteile hat.

Gegenüber dem eingangs beschriebenen Rogowski-Wandler hat das beschriebene Gerät den Vorteil eines einfacheren Aufbaus, den Verzicht auf einen Integrator und die besseren Meßgenauigkeit.

Bei einer bevorzugten Auslegung weist der Sekundärleiter des Wandlers eine Stromdichte von weniger als 0,5 A/mm², vorzugsweise weniger als 0,2 A/mm² auf, bei Nennströmen zwischen 25 A und 2500 A.

Die geringen Eigenverluste kommen auch dadurch zum Ausdruck, daß vorgesehen ist, daß der Außenabschlußwiderstand bei Nennströmen zwischen 25A und 2500 A eine Scheinleitung von deutlich kleiner als 1 VA aufweist.

Durch die Wahl eines Außenabschlußwiderstands im Ohmbereich werden auch die Anforderungen an den Einganswiderstand einer nachgeschalteten Elektronik vermindert. Hier genügen Werte im kΩ-Berich, um eine Verfälschung des Spannungssignals zu verhindern. Da keine Leitung übertragen werden muß, kann es insbesondere bei Hochspannungsanlagen vorteilhaft sein, den Spannungsausgang des Gerätes mit einer Umwandlereinheit zu verbinden, die Licht als Ausgangssignal liefernd ausgebildet ist. Eine leitende Verbindung wird zu den nachgeschalteten Datenerfassungsgeräten durch den Lichtleiter vermieden. Dadurch kann die Sicherheit wesentlich erhöht werden.

Die Erfindung wird in einer bevorzugten Ausführungsform unter Bezugnahme auf eine Zeichnung beschrieben, wobei weitere vorteilhafte Einzelheiten den Figuren der Zeichnung zu entnehmen sind. Funktionsmäßig gleiche Teile sind dabei mit denselben Bezugszeichen versehen.

Die Zeichnungen zeigen im einzelnen:
- Fig. 1: zeigt das Schaltbild der erfindungsgemäßen Strommeßvorrichtung und
- Fig. 2: eine teilangeschnittene axiale Seitenansicht eines Wandlers.

Die Anschlüsse eines Primärleiters 1 sind mit P1 und P2 gekennzeichnet. Dieser Primärleiter ist von einem Sekundärleiter 2, der eine Induktivität L bildet, bestehend aus Kern und Sekundärwicklung, umschlossen, wobei die Anschlüsse des Sekundärleiters 2 mit S1 und S2 gekennzeichnet sind. Leitend mit den Anschlüssen S1 und S2 des Sekundärleiters 2 ist parallel zum Sekundärleiter 2 eine Bürde 3 geschaltet, an der eine dem durch den Primärleiter 1 fließenden Strom proportionale Spannung abfällt. Diese Spannung wird mittels einer Spannungsmeßkette 4 erfaßt.

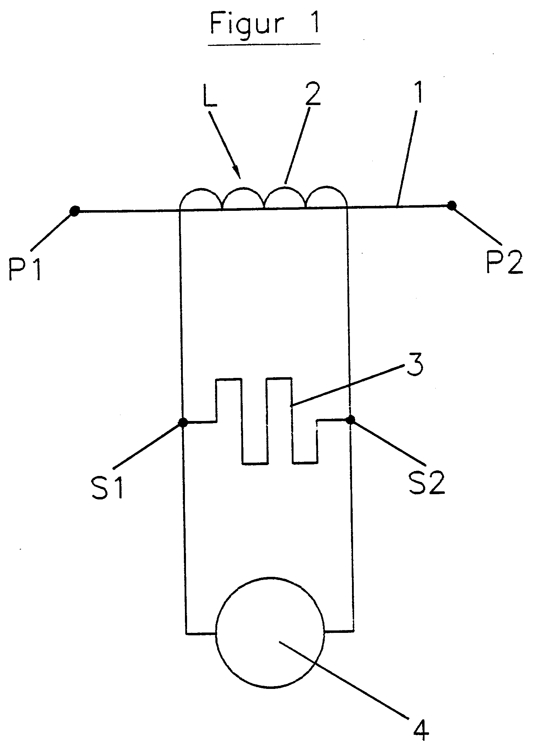

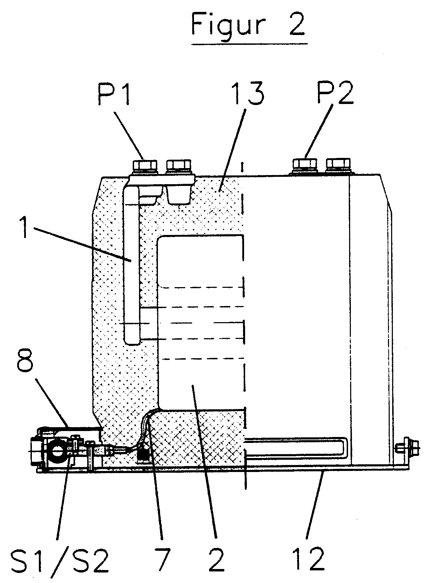

In Figur 2 ist die gegenständliche Ausgestaltung eines in Figur 1 als Teil der Meßvorrichtung dargestellten Stromwandlers gezeigt. Der Primärleiter 1 wird von dem Sekundärleiter 2 umschlossen. Dieser als Induktivität L bezeichnete Teil weist einen innenliegenden Kern und eine Wicklung auf. Ein Anschluß der Sekundärwicklung ist mittels Anschlußkabel 7 in den Klemmenkasten 8 geführt.

Die Anschlüsse P1 und P2 des Primärleiters 1 sind in Form von Schraubanschlüssen nach außen herausgeführt.

Der gesamte Wandler ist auf einer Bodenplatte 12 montiert. Die einzelnen im Inneren angeordneten Teile sind mittels einer geeigneten Vergußmasse 13 festgelegt und isoliert.

Die Bürde 3 kann im Klemmenkasten 8 vorgesehen sein oder in einer Spannungsmeßkette 4, deren Eingänge auf die entsprechenden Anschlüsse im Klemmenkasten 8 geführt werden.

Bei der erfindungsgemäßen Auslegung der Strommeßvorrichtung kann auf den üblicherweise gewickelten Primärleiter verzichtet werden. Statt dessen wird der Primärleiter als einzelner Leiter durch den Ringkern geführt.

Auf diese Weise sind bei erfindungsgemäßer Auslegung auch klassische induktive Wandler überraschenderweise als Einleiterwandler ausführbar. Sie weisen dabei vorteilhaft geringe Abmessungen auf. Mit ihnen lassen sich Ströme messen, die über Iₜₕₑᵣₘ überlicherweise noch hinausgehen. Typisch lassen sich bei Mittelspannungen Ströme von Iₜₕₑᵣₘ = 40 kA, d.h. I_{dyn} = 100 kA noch messen. Dabei wird eine überraschend gute Genauigkeit erzielt. Auf den Einsatz von Rogowski-Kernen kann vorteilhaft verzichtet werden.

### Bezugszeichenliste

- 1: Primärleiter
- P1: Anschluß
- P2: Anschluß
- L: Induktivität
- 2: Sekundärleiter
- S1: Anschluß
- S2: Anschluß
- 3: Bürde
- 4: Spannungsmeßstelle
- 7: Anschlußkabel
- 8: Klemmenkasten
- 12: Bodenplatte
- 13: Vergußmasse

## Patentansprüche

1. Strommeßvorrichtung für Nieder-, Mittel- und Hochspannungsanlagen bestehend aus einem Meßwandler und einem Außenabschlußwiderstand zur Signalverarbeitung, **dadurch gekennzeichnet**, daß als Meßwandler (1,2) ein induktiver Wandler, bestehend aus Primärleiter 1 und Sekundärleiter 2, mit einem Innenwiderstand vorgesehen ist, der größer als der Außenabschlußwiderstand (3) ist.

2. Strommeßvorrichtung nach Anspruch 1, **dadurch gekennzeichnet**, daß der Innenwiderstand des Sekundärleiters (2) mindestens um eine Zehnerpotenz größer als der Außenabschlußwiderstand (3) ist.

3. Strommeßvorrichtung nach Anspruch 1 oder 2, **dadurch gekennzeichnet**, daß der Meßwandler als Einleiterwandler ausgebildet ist.

4. Strommeßvorrichtung nach Anspruch 1, 2 oder 3, **dadurch gekennzeichnet**, daß weniger oder gleich 1 A bei Nennstrom im Sekundärleiter (2) fließen.

5. Strommeßvorrichtung nach Anspruch 1, 2, 3 oder 4, **dadurch gekennzeichnet**, daß der Wandler einen Spannungsausgang aufweist, wobei vorzugsweise am Außenabschlußwiderstand (3) bei thermischem Grenzstrom eine Spannung von etwa 10V abfällt.

6. Strommeßvorrichtung nach Anspruch 1, 2, 3, 4 oder 5, **dadurch gekennzeichnet**, daß der Sekundärleiter (2) des Wandlers eine Stromdichte von weniger als 0,5 A/mm², vorzugsweise weniger als 0,2 A/mm^{2,} bei Nennströmen zwischen 25 und 2500 A im Primärleiter aufweist.

7. Strommeßvorrichtung nach Anspruch 1, 2, 3, 4, 5, oder 6, **dadurch gekennzeichnet**, daß der Außenabschlußwiderstand (3) bei Nennströmen von 25 A bis 2500 A eine Scheinleitung von kleiner oder gleich 1 VA, vorzugsweise kleiner 0,5 VA, aufweist.

8. Strommeßvorrichtung nach Anspruch 1, 2, 3, 4, 5, 6, oder 7, **dadurch gekennzeichnet**, daß als Außenabschlußwiderstand (3) die Eingangsimpedanz einer Auswerteschaltung vorgesehen ist.

9. Strommeßvorrichtung nach Anspruch 1, 2, 3, 4, 5, 6, 7 oder 8, **dadurch gekennzeichnet**, daß der Sekundärleiter (2) im Wandler bei Iₜₕₑᵣₘ eine Stromdichte kleiner 50 A/mm², vorzugsweise kleiner als 20 A/mm², aufweist.

10. Strommeßvorrichtung nach einem oder mehreren der vorhergehenden Ansprüche, **dadurch gekennzeichnet**, daß der Meßwandler mit einer Umwandlereinheit eine Einheit bildend geformt ist, wobei die Umwandlereinheit Licht als Ausgangssignal liefernd ausgebildet ist.
